(19) Europäisches Patentamt
European Patent Office
Office européen des brevets

(11) EP 0 660 656 B1

(12) **EUROPEAN PATENT SPECIFICATION**

(45) Date of publication and mention
of the grant of the patent:
**10.03.1999  Bulletin 1999/10**

(51) Int Cl.⁶: **H05K 13/08**

(21) Application number: **94120703.7**

(22) Date of filing: **27.12.1994**

(54) **Method and mounting device for mounting a component at a specific position**

Verfahren und Montagevorrichtung zum Montieren eines Bauelementes auf eine spezifische Position

Méthode et dispositif de montage pour le montage d'un composant sur une position spécifique

(84) Designated Contracting States:
**DE NL**

(30) Priority: **27.12.1993 JP 331221/93**
**29.12.1993 JP 352710/93**

(43) Date of publication of application:
**28.06.1995  Bulletin 1995/26**

(60) Divisional application: **97118277.9 / 0 833 555**

(73) Proprietor: **YAMAHA HATSUDOKI KABUSHIKI KAISHA**
**Iwata-shi Shizuoka-ken, 438 (JP)**

(72) Inventors:
• **Sakurai, Hiroshi**
**Iwata-shi, Shizuoka-ken, 438 (JP)**

• **Onodera, Hitoshi**
**Iwata-shi, Shizuoka-ken, 438 (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**WO-A-92/14988**

• **PATENT ABSTRACTS OF JAPAN vol. 10 no. 32 (E-379) ,7 February 1986 & JP-A-60 189951 (FUJITSU KK) 27 September 1985,**

## Description

The present invention relates to a method for mounting a component at a specific position, especially a chip component onto a substrate such as a printed circuit board comprising the steps of picking up the component through a pick up nozzle from a component supply unit, transferring the component and mounting the same at the desired position, and placing the component in a detecting area of a position detecting means emitting parallel light beams for detecting a projected width of the component under rotation of the same so as to obtain a correction value for mounting the component precisely.

Furthermore, the present invention relates to a mounting device for mounting a component at a specific position, especially a chip component onto a substrate such as a printed circuit board, comprising a movable mounting head unit supporting at least one pick up nozzle for picking up at least one component from a component supply unit, an optical detecting means for detecting a projected width of said component under rotation of same in parallel light beams emitted from said optical detecting means, and control means for controlling the mounting head and the pick up nozzle, respectively, in response to projected width data.

In a conventional mounter generally known, a head unit having a plural number of pickup nozzles for mounting chip components picks up small-sized chip components such as those for IC's from a component supply section provided with a plural number of rows of tape feeders for instance, moves the components to a positioned printed circuit board, and mount them at specified positions on the printed circuit board. In such a mounter, the head is moved in X axis and Y axis directions, and the pickup nozzles are moved in Z-axis direction and can also rotated. For those movements and rotation, respective drive means are provided. Means for supplying vacuum to those drive means and nozzles are controlled by a control device. Thus, chip components are automatically mounted.

When such a mounter is used, there is a certain scatter in the positions of the picked up components and corrections are required accordingly. For that reason, some known mounters are provided with a head unit having optical detection means such as a laser unit located below the head unit and comprising a light emitting section emitting parallel light beams within a certain plane and a light receiving section to detect projected images of the chip components, and to calculate correction amounts for the mounting positions by detecting the central positions and rotated angles of the chip components according to the detected projected width.

The optical detection means such as a laser unit described above is constituted so that the pickup nozzles are raised or lowered to keep the components at specified heights preset according to the types of the chip components when they are recognized by the optical detection means, and that the projected widths of the chip components are detected accurately for each component.

However, even if the chip components are kept at the preset heights according to the types of the chip components and the projected widths are detected by the optical detection means, actually the detected projected width data may include noise due to diffraction of light when the chip components are very small. In such cases, use of data including noise due to diffraction to calculate the correction amount for the mounting position leads to incorrect pickup of the chip component, or to discarding the chip component when the detected projected width data is determined as incorrect.

Here, the noise due to the diffraction phenomenon when the chip component is very small occurs in different magnitudes depending on the position, especially the height, of the chip component relative to the light emitting section and the light receiving section. The noise may or may not occur depending on the minute difference in the height. Therefore, fine height adjustment is required to avoid the noise. Such fine adjustment, however, is difficult with the conventional arrangement in which the chip component height is predetermined at the time of detecting projected width.

When a chip component is placed in a detection area of such an optical detecting means in order to calculate correction amounts for the mounting positions or generally to discriminate whether or not the picked up state of the chip component is normal, usually the minimum projected width of the chip component is measured by checking the projected width while rotating the chip component and is compared with a reference value, see e.g. WO-A-92/14988. Since there is a certain scatter in the minimum values of the projected widths measured owing to detection errors, consideration is given to the arrangement so that the minimum value is determined as normal as long as it is between an upper and lower reference value, said upper reference value being greater than the chip width by a certain amount and said lower reference value being smaller by a certain amount.

When parallel light beams are cast on the chip component located between the light emitting section of the optical detection means and the light receiving section, it is expected that the minimum value of the projected width is equal to the width of the chip component as long as the light beams travel perfectly in straight lines. Actually, however the light beams do not travel in straight lines but undergo diffraction and interference and tend to diffuse over the distance from the chip component to the light receiving section. This leads to a phenomenon that the minimum value of the projected width is somewhat larger than the actual width of the chip component even if the chip component is picked up correctly.

Therefore it is difficult to discriminate whether or not the chip component is picked up correctly by comparing the minimum value of the projected width with the width of the chip component. On the other hand, it is possible to provide an arrangement as described above that the minimum value of the projected width for a correct picked up state falls within a tolerance range given to the reference value by increasing such a tolerance range even if the phenomenon as described above occurs. However, if the tolerance range is increased when the chip component is very small, it is possible that the minimum value of the projected width falls within the tolerance range even when the chip component is not picked up correctly. Thus, correct discrimination of the picked up state of the component becomes impossible.

It is therefore an objective of the present invention to provide an improved method and an improved device for mounting a component, wherein the effects of light diffraction and interference are eliminated or at least reduced so as to recognise the component and its picked up state more accurately.

According to the present invention, the above-mentioned objective concerning the method is performed by the steps of determining whether or not data characteristics of the projected width correspond with given data characteristics representing a correct pick up state and when not, displacing the component from the first position to a second position within the parallel light beams in a direction substantially perpendicular to the parallel light beams for detecting the projected width once again.

An embodiment of the invention includes the steps of calculating a detection error in the projected width due to light diffraction on the basis of a distance between the component in the detecting area and a detecting section of said position detecting means, calculating a component width on the basis of the projected width and said detection error, and comparing said component width with a reference value for deciding whether or not the component is picked up correctly.

According to the present invention the above-mentioned objective concerning the device is performed in that a comparator means is provided for comparing the projected width data with reference data to determine whether or not the projected width data represent a correct pick up state and the control means is adapted to displace the mounting head and the pick up nozzle respectively in a direction perpendicular to the light beams to detect the projected width of the component once again at a different position within said light beams when the projected width data does not represent a correct pick up state.

An embodiment of the invention includes memory means for storing a detection error in the projected width, said detection error being calculated on the basis of a distance between the component placed in the light beams and a detecting section of the optical detecting means, calculating means for calculating a component width on the basis of a minimum projected width and said detection error, and by comparator means for comparing the component width with a reference value for deciding whether or not the component is picked up correctly.

Preferred embodiments of the invention are laid down in further dependent claims.

Hereinafter the present invention is illustrated and explained in greater detail by means of preferred embodiments in conjunction with accompanying drawings, wherein:

Fig. 1 is a plan view of a mounting device including a mounting head unit and a component supply unit according to a first embodiment of the invention;

Fig. 2 is a front elevational view showing the mounting device according to the embodiment of fig. 1;

Fig. 3 shows in an enlarged view the mounting head unit including three pick up nozzles according to the embodiment of fig. 1;

Fig. 4 is a block diagram showing the control system of the mounting device according to the embodiment of fig. 1;

Fig. 5 is a flow chart showing the operations of pick up, recognition and mounting of a component;

Fig. 6 is a flow chart showing the pick up point changing control of the mounting device according to the embodiment of fig. 1;

Fig. 7 shows schematically a chip component placed in a detecting area between a light emitting section and a light receiving section of a position detecting means, the component being depicted in different rotational positions, according to the embodiment of fig. 1;

Fig. 8 is a graph showing the projected component width depending on the rotation angle of the pick up nozzle of the mounting head unit according to the embodiment of fig. 1;

Fig. 9 is a plan view showing a mounting device including a mounting head unit and a component supply unit according to a second embodiment of the invention;

Fig. 10 is a front elevational view showing the mounting device according to the embodiment of fig. 9;

Fig. 11 shows in an enlarged view the essential parts of a mounting head unit including two pick up nozzles according to the embodiment of fig. 9;

Fig. 12 shows the lay out of the pick up nozzles and a laser unit including a light emitting section and a light receiving section according to the embodiment of fig. 9;

Fig. 13 is a block diagram showing a control system of the mounting device according to the embodiment of fig. 9;

Fig. 14 shows schematically the light diffusion phenomenon during determining the projected width of a component recognised by a laser unit;

Fig. 15 is a flow chart showing the control of a series of process of pick up recognition and mounting of a chip component according to the embodiment of fig. 9;

Fig. 16 shows schematically the component state and the projected width at the time of component recognition, and;

Fig. 17 shows schematically different picked up states of a chip component, wherein a represents a correct picked up state, while b and c show an incorrect picked up state of the component, according to the embodiment of fig. 9.

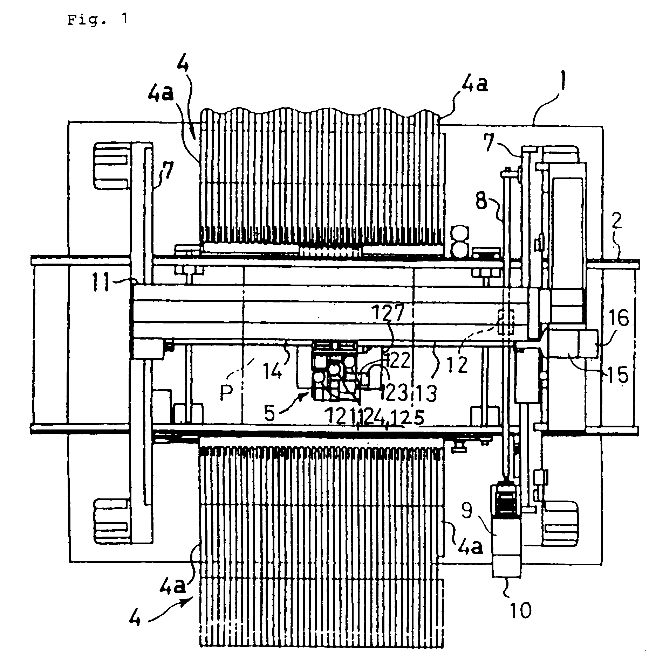

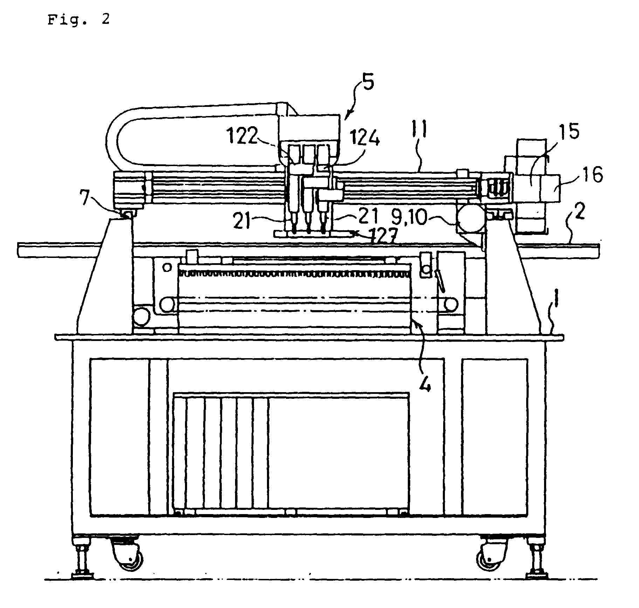

Hereinafter a first embodiment of a mounting device will be described with reference to figs. 1 to 8. As shown in the drawing, a conveyor 2 for conveying printed circuit boards is located on a frame 1. The printed circuit boards P are conveyed along the conveyor 2 and positioned and held at a specified mounting work position.

Component supply sections 4 are located on both sides of the conveyor 2. The component supply section 4 comprises a plural number of rows of tape feeders 4a. Each tape feeder comprises a tape to be drawn out from a reel and holding small-sized chip components such as those for IC's, transistors, and capacitors at specified intervals. A ratchet type feeder mechanism is provided at the tape feed out end so that the tape is periodically fed out as the chip components are picked up by a head unit 5 which will be described later.

The head unit 5 for mounting components is located above the frame 1 to be capable of moving in directions of X axis (conveyor movement) and Y axis (normal to the X axis in horizontal plane).

A pair of fixed rails 7 extending in the Y direction and a ball screw axis 8 rotatably driven by a Y axis servomotor 9 are located on the frame 1. A head unit support member 11 is installed on the fixed rails 7. A nut 12 provided on the support member 11 is in screw engagement with the ball screw axis 8. The support member 11 is also provided with a guide member 13 extending in the X axis direction, and a ball screw axis 14 rotatably driven by an X axis servomotor 15. The head unit 5 is movably supported by the guide member 13. A nut (not shown) mounted in the head unit 5 is in screw engagement with the ball screw axis 14. When the ball screw axis 8 is rotated by the operation of the Y axis servomotor 9, the support member 11 moves in the Y axis direction. When the ball screw axis 14 is rotated by the operation of the X axis servomotor 15, the head unit 5 moves in the X axis direction along the support member 11.

The Y axis servomotor 9 and the X axis servomotor 15 are respectively provided with position detection means 10 and 16 comprising encoders.

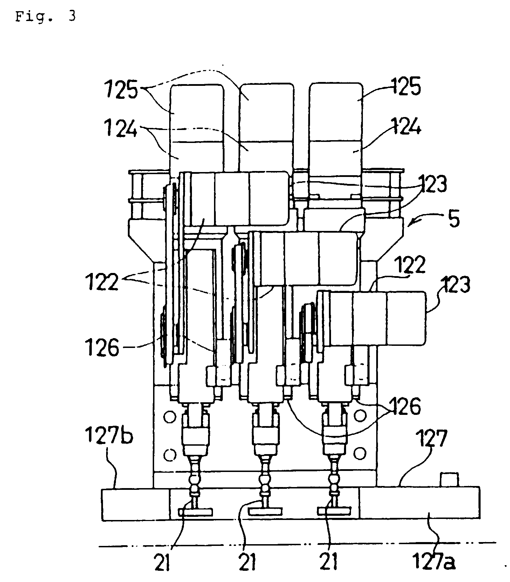

As shown in FIG. 3 in detail, the head unit 5 is provided with pickup nozzles 21 for picking up chip components. In the embodiment shown, the number of the nozzles 21 is three. Each pickup nozzle 21 is capable of moving in the Z axis (up and down) direction and rotating about Z axis (nozzle center axis) and respectively driven by a Z axis servomotor 122 and an R axis servomotor 124. The servomotors 122 and 124 are respectively provided with detection neans 123 and 125 comprising encoders.

In the head unit 5, each pickup nozzle 21 is provided with interference position detection means 126 for detecting a position of the pickup nozzle 21 interference with the component supply section 4.

Vacuum means (not shown) is connected to the pickup nozzles 21 by way of a valve or the like to apply vacuum to the pickup nozzles 21 when required to pick up chip components.

A laser unit 127 is attached to the lower end of the head unit 5. The laser unit 127 detects projected width of the chip component when parallel light beams or laser beams are cast on the chip component in the state of being picked up. Two components of the laser unit 127, a laser generating section (parallel beam casting section) 127a and a detector (photocell section) 127b comprising a CCD, facing each other, are located on both sides of the pickup nozzle 21.

The pickup nozzles 21 and the laser unit 127 of the head unit 5 are located to avoid overlapping of the pickup nozzles 21 each other in the direction of casting laser beams. In other words, in the embodiment (FIG. 1, though not much in detail), while the laser unit 127 is oriented so that the laser beams are cast in the X axis direction, the pickup nozzles 21 are obliquely staggered with respect to the X axis, and that the images of the nozzles 21 are projected on different areas of the detector 127b of the laser unit 127. While the chip components are usually picked up as shown in FIG. 1, one component for each pickup nozzle 21, a relatively large chip component will be picked up by the pickup nozzle 21 in the center only, or by the pickup nozzles on both sides only. Thus, the pickup nozzles 21 are suitably selected according to the sizes of the chip components to be picked up.

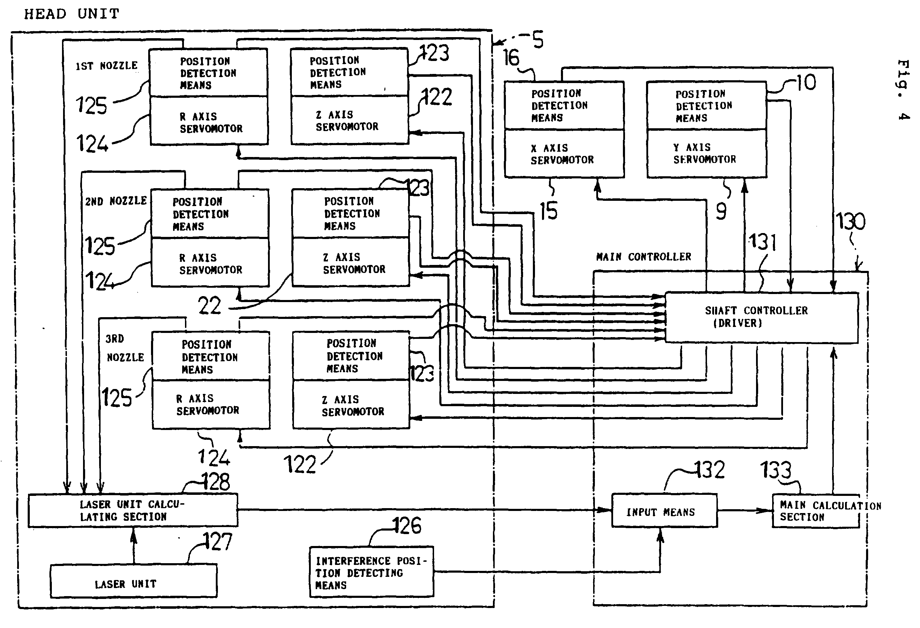

FIG. 4 shows an embodiment of a control system for the mounter described above.

In the drawing, electric connections are made from a shaft controller (driver) 131 of a main controller 130 to the servomotors 9, 15.1 22 and 124, and the position detection means 10, 16, 123 and 125 respectively provided on those servomotors. The laser unit 127 is electrically connected to a main calculating section 133 by way of an input output means 132. The main calculating section 133 is further connected to an average correction amount calculating section. Interference position detection means 126 is connected to the input output means 132.

The main calculating section 133 performs automatic pickup and mounting of the chip components according to a program preset according to the circuit board on which the chip components are to be mounted. At the time of component recognition, the main calculating section 133 controls the operations of the servomotors 9, 15, 122 and 124 by way of the shaft controller 131 to detect the projected widths of the picked up chip components, while holding them at a specified height and rotating them, by means of the laser unit 127.

The main calculating section 133 along with performing the process of determining the mounting position correction amounts for the chip components to be mounted according to signals issued from the laser unit calculating section 128 through the input output means 132, namely according to signals representing the projected chip component widths W detected by the laser unit 127. discriminates whether or not the signal representing the detected projected width W and, if not correct, controls the operation of the servomotors 122 and 124 through the shaft controller 131 so as to raise (or lower) the chip component held at a component recognition height (Z) by a small distance ($\Delta$Z) and to recognize the component again by the laser unit 127. In other words, the main calculating section 133 in the mounter serves as projected width information discriminating means.

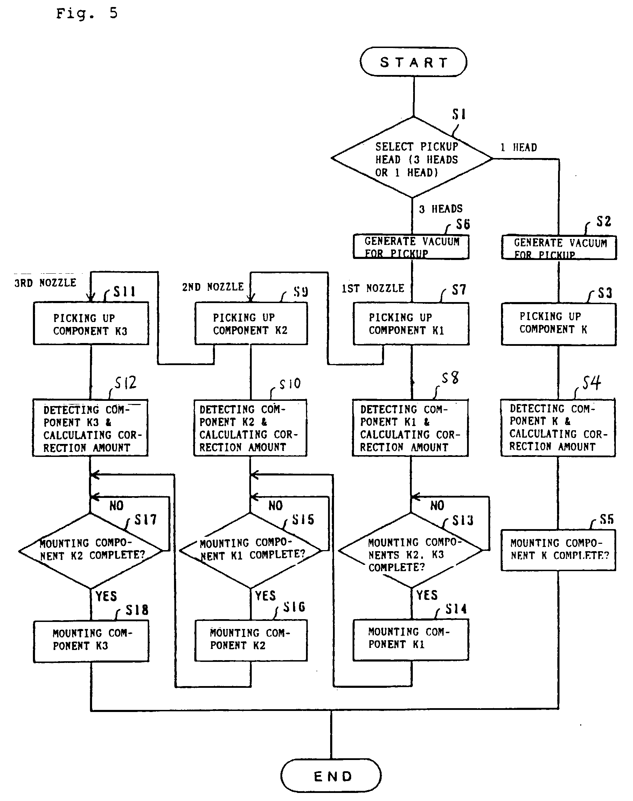

An example of control by the main controller 130 will be described below In reference to the flow chart shown in FIG. 5.

FIG. 5 shows a main routine of entire process of the chip component pickup and mounting operations. While the mounter described above is capable of performing the mounting operation by selectively using any number of the three pickup nozzles 21 according to the sizes of the chip components, the following description is made about selective use of either one or three pickup nozzles 21 for the mounting operation.

First in step S1, discrimination is made according to the size of the chip component to be mounted whether the mounting operation should be performed by one pickup nozzle 21 or by three pickup nozzles 21.

When the mounting operation by one pickup nozzle 21 is selected in the step S1, the process proceeds to step S2. In the step S2, vacuum is applied from a vacuum generating means (not shown) to one of the three pickup nozzles 21, and the head unit 5 is moved in the X axis and Y axis directions. When the head unit 5 reaches a position corresponding to the component supply section 4, the pickup nozzle 21 is lowered and an intended chip component K is picked up (step S3).

When the pickup of the chip component K is complete, the pickup nozzle 21 is raised, the head unit 5 is moved to the printed circuit board side to mount the chip component K. During the movement of the head unit 5, the chip component K is recognized (the chip component K is detected and the correction value for the component mounting position is calculated according to the detected data) by the laser unit 127 (step S4).

When the head unit 5 reaches a position corrected by the correction value, the pickup nozzle 21 is lowered with simultaneous stop of application of vacuum to the pickup nozzle 21, and the mounting of the chip component K to the printed circuit board is complete (step S5).

When mounting operation by three pickup nozzles 21 is selected in the step S1 (in the following description of the process flow, discrimination will be made to call them respectively as the first, second, and third pickup nozzles), the process proceeds to step S7. Here, the operations of the first through third pickup nozzles are fundamentally identical each other, and operation periods of respective pickup nozzles overlap each other.

In other words, simultaneous with the application of vacuum for chip component pickup to the first through third pickup nozzles in step S6, the head unit 5 is moved to the component supply section 4, the first nozzle 21 is lowered, and an intended chip component K1 is picked up (step S7).

When pickup of the chip component K1 by the first pickup nozzle is complete, the head unit 5 is moved for picking up a chip component by the second pickup nozzle. When the head unit 5 reaches a position above the component supply section 4, the second pickup nozzle lowers and picks up the intended chip component K2. At the same time, component recognition for the chip component K1 picked up by the first pickup nozzle is performed by the laser unit 127 (steps S8 and S9).

When pickup of the chip component K2 by the second pickup nozzle is complete, the head unit 5 is moved for picking up a chip component by the third pickup nozzle. When the head unit 5 reaches a position above the component supply section 4, the second pickup nozzle lowers and picks up the intended chip component K3. At the same time. component recognition for the chip component K2 picked up by the second pickup nozzle is performed by the laser unit 127 (steps S10 and S11).

When pickup of the chip component K3 by the third pickup nozzle is complete, component recognition for the chip component K3 picked up by the third pickup nozzle is performed by the laser unit 127 (steps S12).

On the other hand, after the completion of the component recognition of the chip component K1 in the step S8, discrimination is made in step S13 if the pickups of the chip components K2 and K3 are complete. If the pickup of the chip component K3 is complete (YES in the step S13), the process proceeds to step S14 to mount the chip component K1. Namely, the head unit 5 is moved to the printed circuit board side, or to the position corrected with the correction amount for mounting the chip component K1. When the head unit 5 reaches the intended position, the first pickup nozzle lowers while vacuum is gradually weakened so that the chip component K1 is mounted on the printed circuit board. Then the process proceeds to step S15.

In the step S15, it is discriminated whether mounting the chip component K1 by the first nozzle is complete. If complete (YES in the step S15), the process proceeds to step S16 to mount the chip component K2, and proceeds to step S17. In the step S17, it is discriminated whether mounting the chip component K2 by the second nozzle is complete. If complete (YES in the step S17), the process proceeds to step S18 to mount the chip component K3.

When mounting the chip component K3 by the third nozzle is complete, the process of the flow chart is over.

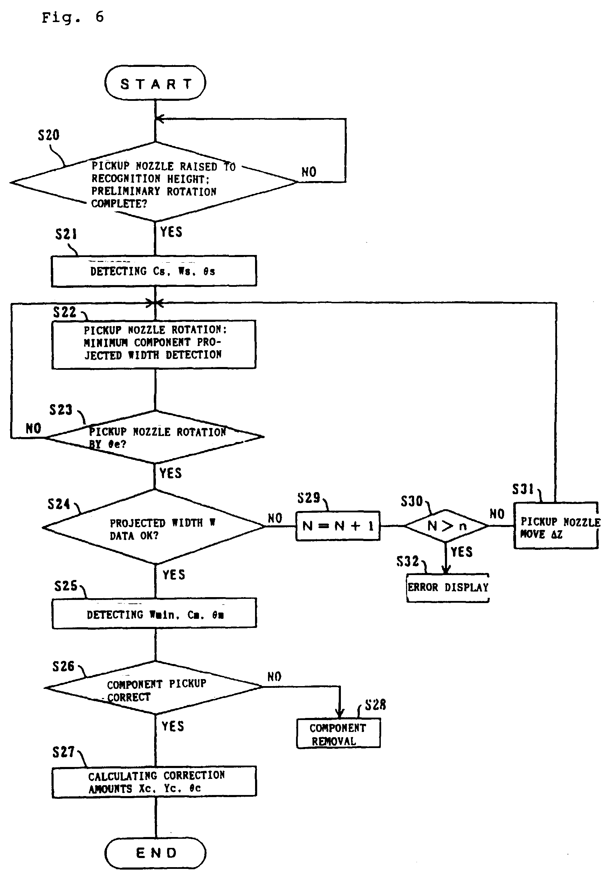

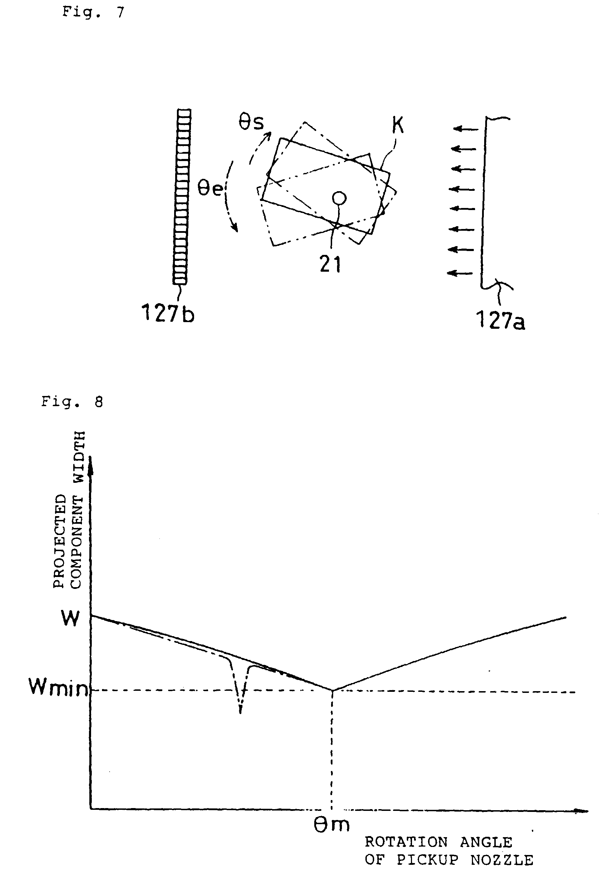

Next, process of changing the pickup point while picking up and mounting the component (chip component recognition operation performed in the steps S4, S8, S10, and S12) are being done will be described in reference to FIGs. 7 and 8, and the flow chart shown in FIG. 6. In the following description, it is assumed that the shape of the chip component K is rectangular.

When the chip component is picked up by the first nozzle 21 from the component supply section 4, the chip component in the state of being picked up by the pickup nozzle 21 is raised to a specified height for recognition, and rotated by a specified angle with respect to the direction of the laser beam (X axis direction) of the laser unit 127 (preliminary rotary action). This places the chip component in an initial position with its longer side tilted relative to the direction of the laser beam of the laser unit 127. More specifically as shown in FIG. 7, the chip component K (shown with solid lines) picked up by the pickup nozzle 21 is in a state of being placed within the laser beams and rotated in the negative (clockwise in FIG. 8) direction by a certain angle θs (shown with phantom lines) with a longer side of the chip component K being tilted relative to the direction of beams from the laser unit 127.

In the step S20 of the flow chart, it is discriminated whether the pickup nozzle 21 is raised to the specified recognition height and the preliminary rotary action is complete. If complete (YES in the step S20), the process proceeds to step S21.

In the step S21, the chip component placed in the initial position as described above is detected for its projected width Ws, central position Cs, and rotary angle θs at that time point.

When the above detection is complete, measurement of the projected width W of the chip component is repeated while the chip component is rotated from the initial position shown in FIG. 8 with double-dotted phantom lines by a specified angle of θe (steps S22 and S23). The change in the projected width W according to the rotation angle θ is shown in FIG. 8 in which a longer side of the chip component K is in line with the laser beam direction in the course of rotation by a certain angle where the projected width W becomes the minimum.

In step S24, it is discriminated whether or not the data characteristic of the projected width W of the chip component K detected during the rotation of the pickup nozzle 21 as described above is correct. If the data characteristic is correct, namely if the projected width W gradually decreases in the course of the rotation of the chip component by a certain angle and later increases as shown in FIG. 8, the process proceeds to step S25 (YES in the step S24), and the minimum projected width Wmin is obtained from the data of the projected width W. At the same time, the central position Cm, and rotation angle θm at that time point are detected, and the process proceeds to step S26.

In the step S26, it is discriminated whether or not the chip component is picked up correctly on the basis of the data (Wmin, Cm, θm) obtained as described above. If not correct (NO in the step S26), the process proceeds to step S28, the chip component is removed. If correct, the process proceeds to step S27, and mounting position correction amounts Xc, Yc, and θc in the directions X, Y, and θ are calculated from the detected data. In other words, in the step S27, the minimum projected width Wmin, the length of the shorter side, displacement of the chip component in the shorter side direction relative to the nozzle center, and rotation angle displacement of the chip component K are obtained from the central position Cm, and rotation angle θm. From these and other data, the length of the longer side, and the displacement of the component center in the longer side direction relative to the nozzle center are calculated. From these results, the mounting position correction amounts Xc, Yc, and θc are calculated.

If the data characteristic of the projected width W detected is not correct in the step S24, namely if the projected width W does not show the characteristic of gradually decreasing in the course of rotation of the chip component K by a certain angle but, as shown in FIG. 8 with single-dotted phantom lines, shows minimum data at plural points, the pickup nozzle 21 is once rotated in the negative direction to reset the chip component in the initial position. Then the pickup nozzle 21 is raised (or lowered) relative to the specified recognition height (Z) by a small distance (ΔZ) and at the same time a counter (not shown) counts up (steps S29 through S31) and returned to the step S22. In other words, the chip component recognition height is increased by the small distance (ΔZ) and the projected width W of the chip component K is detected again.

If the data characteristic of the projected width W is determined as correct in the step S24 (YES in the step S24), the process proceeds to step S25, and the minimum projected width Wmin, central position Cm, and rotation angle θm are detected. If the detected data is not correct even In the second detection (NO in the step S24), the process is again returned to the steps S29 and S30, the chip component recognition height is further raised by the small distance (ΔZ), and the projected width W of the chip component K is detected.

If the data characteristic of the projected width W is not determined as correct even if the detection of the projected width W is repeated by raising (or lowering) the chip component recognition height for a predetermined number of times (YES in the step S30), the process proceeds to step S32 in which the situation is alarmed to an operator by, for instance, alarm means (not shown).

As described above, it is possible with the mounter to automatically perform a series of operations of the mounting position correction and component mounting on the basis of the pickup and recognition of the chip component. At the time of the component recognition in particular, the projected width W is detected by the laser unit 127 while keeping the chip component at the recognition height (Z) commensurate with the type of the chip component after the chip component is picked up, and the mounting position correction value is obtained from the detected data. At the same time, it is discriminated whether or not the data characteristic of the projected width W detected by the laser unit 127 is correct. If not correct, the projected width W is detected again after raising (or lowering) the chip component height (Z) at the time of the component recognition by a small distance. Therefore, even if noise is included in the data representing the projected width W of the chip component as a result of diffraction of the laser beams, a second detection of the projected width W is automatically performed. This improves the accuracy in the component recognition and, unlike conventional arrangement, reduces the number of chip components treated as defective, and enhances the mounting efficiency of the mounter.

The embodiment described above shows only one of embodiments of this invention and the specific structure is not limited to the above embodiment. For instance, while the number of the nozzles 21 is three in the embodiment, the number may be greater or smaller than three. For other structural features other than the number of the nozzles, they may be changed within the scope of this invention as defined in the appendent claims.

As described above, according to this embodiment, the pickup nozzle is raised to a specified height by the control means after the component is picked up by the pickup nozzle, and the projected width of the chip component is detected by the optical detection means. On the basis of the detected values, the central position and the rotation angle of the component are detected and the component mounting position correction amount is obtained by the correction amount calculating means. Here, if the information issued from the optical detection means and representing the projected width is not correct, the pickup nozzle is raised or lowered by the control means to raise or lower the chip component within the parallel light beams of the optical detection means, and the projected width is detected again by the optical detection means. Thus, the chip component is recognized more accurately.

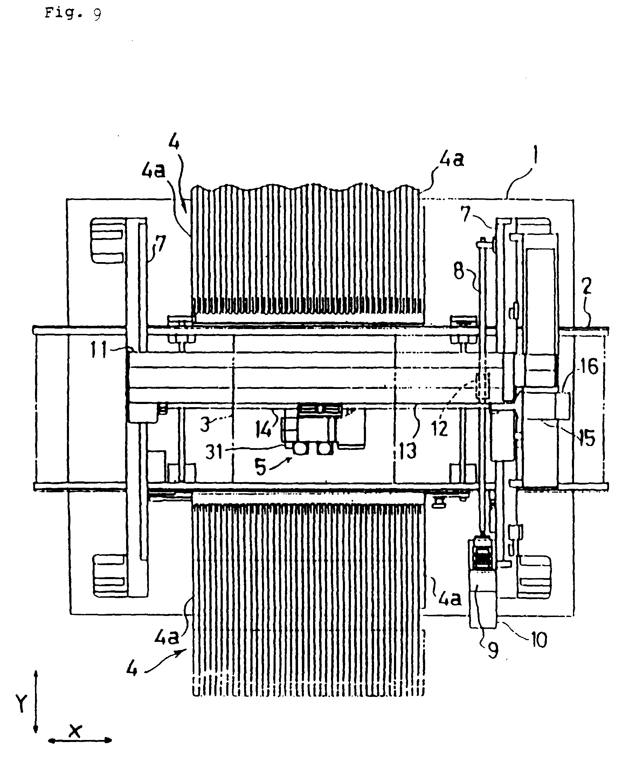

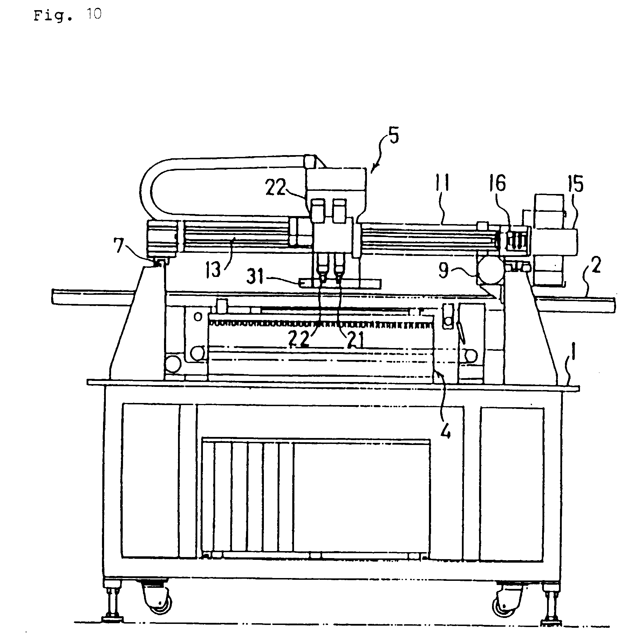

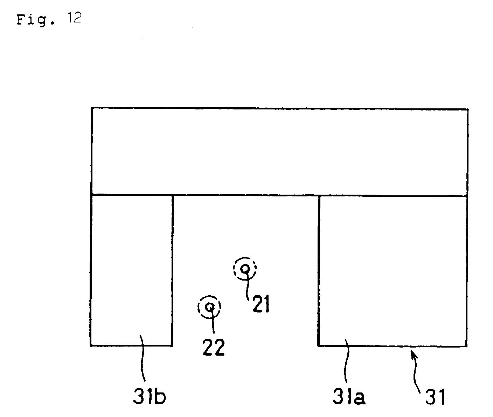

Hereinafter a second embodiment of a mounting device will be described with reference to figures 9 to 17. It is to be noted that some similar components will be denoted by the same reference numerals as for the first embodiment.

As shown in the drawings, a conveyor 2 for conveying printed circuit boards 3 is arranged on a frame 1 so that the printed circuit boards 3 are conveyed on the conveyor 2 and stopped at specified mounting work position.

Component supply sections 4 are arranged on either side of the conveyor 2. Each of the component supply sections 4 is provided with a plural rows of tape feeders 4a on which small-sized chip components such as those for IC's, transistors, condensers, etc. are held at specified intervals. The tape is reeled out periodically by a feeder mechanism provided at the tape feed out end as the chip components are picked up by a head unit 5 which will be described later.

The head unit 5 for mounting components is located above the frame 1 to be capable of moving in X axis (conveyor movement) and Y axis (normal to the X axis in horizontal plane) directions.

A pair of fixed rails 7 extending in the Y direction and a ball screw axis 8 rotatably driven by a Y axis servomotor 9 are located on the frame 1. A head unit support member 11 is movably installed on the fixed rails 7. A nut 12 provided on the support member 11 is in screw engagement with the ball screw axis 8. The support member 11 is also provided with a guide member 13 extending in the X axis direction, and a ball screw axis 14 rotatably driven by an X axis servomotor 15. The head unit 5 is movably supported by the guide member 13. A nut (not shown) mounted in the head unit 5 is in screw engagement with the ball screw axis 14. When the ball screw axis 8 is rotated by the operation of the Y axis servomotor 9, the support member 11 moves in the Y axis direction. When the ball screw axis 14 is rotated by the operation of the X axis servomotor 15, the head unit 5 moves in the X axis direction along the support member 11.

(0018)

The Y axis servomotor 9 and the X axis servomotor 15 are respectively provided with position detection means 10 and 16 comprising encoders.

The head unit 5 is provided with pickup nozzles: in the embodiment shown, two pickup nozzles 21 and 22. A laser unit 31 as optical detection means is provided at the lower part of the head unit 5.

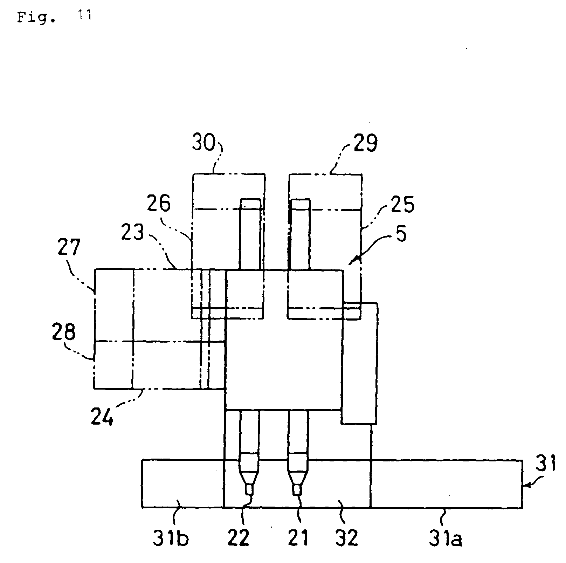

Members provided on the head unit 5 will be described in reference to FIG. 11. The pickup nozzles 21, 22 are capable of moving in Z axis (up and down) direction and rotating about Z axis (longitudinal axis of the nozzle), and operated by Z axis servomotors 23, 24 and R axis servomotors 25, 26. The servomotors 23 through 26 are respectively provided with position detection means 27 through 30. The pickup nozzles 21, 22 are connected to vacuum application means (not shown) for vacuum application by way of valves and the like when vacuum is needed for picking up components.

The first pickup nozzle 21 is located at approximate center of the range corresponding to a space 32 of the laser unit 31. The second pickup nozzle 22 is located obliquely behind the first pickup nozzle 21 (Refer to FIG. 4). Such a pickup nozzle layout is for selective use between the first pickup nozzle 21 only and both pickup nozzles 21, 22. When the chip component is relatively large for instance, only the first pickup nozzle 21 is used to pick up a chip component, while both pickup nozzles 21. 22 are used to pick up two chip components when the chip components are relatively small and component recognition is made by the laser unit 31.

The laser unit 31 is also provided with a parallel light beam emitting section (laser generating section) 31a and a light receiving section (detector) 31b located opposite on both sides of the space 32 through which the pickup nozzles 21, 22 move up and down. The light receiving section comprises a CCD (charge-coupled diode). When the chip component picked up by the pickup nozzle is located in the space 32. laser beams are cast from the light emitting section 31a on the chip component. and laser beams not blocked by the chip component are received by the light receiving section 31b to detect the projected width of the chip component 20.

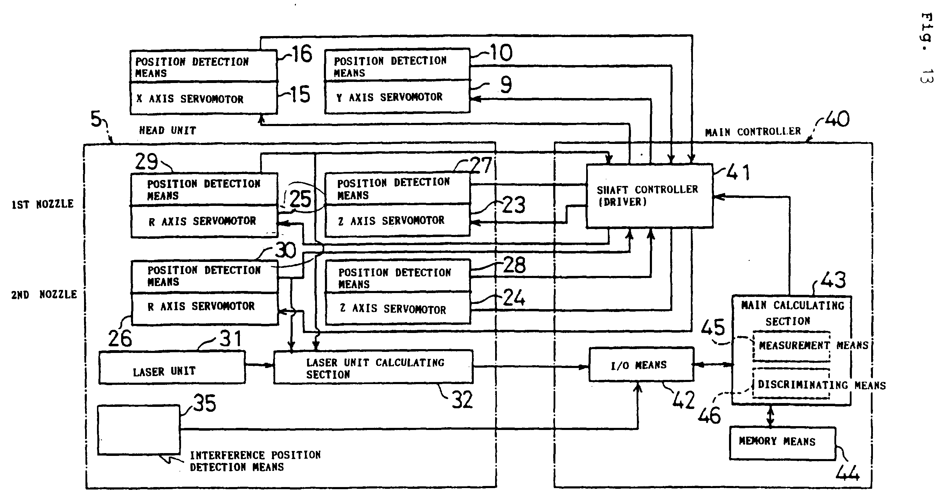

FIG. 13 shows an embodiment of a control system. In the drawing, the Y axis servomotor 9, X axis servomotor 15; and the Z axis servomotors 23, 24, and R axis servomotors 25, 26 corresponding to the pickup nozzles 21, 22 of the head unit 5; and the position detection means 10, 16, 27 through 30 provided on those servomotors are electrically connected to a shaft controller (driver) 41 of a main controller 40 serving as a control section. The laser unit 31 is connected to a main calculating section 43 by way of input/output means 42 of the main controller 40. An interference position detection means 35 for checking if the pickup nozzles 21, 22 are at a height to interfere with the component supply section is also connected to the input/output means 42.

The main controller 40 is also provided with memory means 44 for storing the estimated value of the error in the projected width as a correction amount.

The main calculating section 43 of the main controller 40 is arranged to effect automatic pickup and mounting of the chip component: it controls the operation of servomotors 9, 15, 23 through 26 by way of a shaft controller 41, raises the pickup nozzles to a specified height for component recognition by controlling the Z axis servomotor 24 after the pickup nozzles 21, 22 picking up the chip components, and effects recognition by the laser unit 31 under the condition of the chip components being held at the recognition height.

The main calculating section 43 is provided with measurement means 45 for measuring the minimum width of the chip component by examining the projected width detected by the laser unit 31 while rotating the chip component at the component recognition position. and discriminating means 46 for discriminating whether or not picked up state of the chip component is normal by comparing the chip component width, calculated from the chip component width measured by the measurement means 45 and from a correction amount read out of the memory means 44, with a reference value of the chip component width.

As described above, the component recognition device comprises the laser unit 31, the memory means 44, the measurement means 45, and the discriminating means 46.

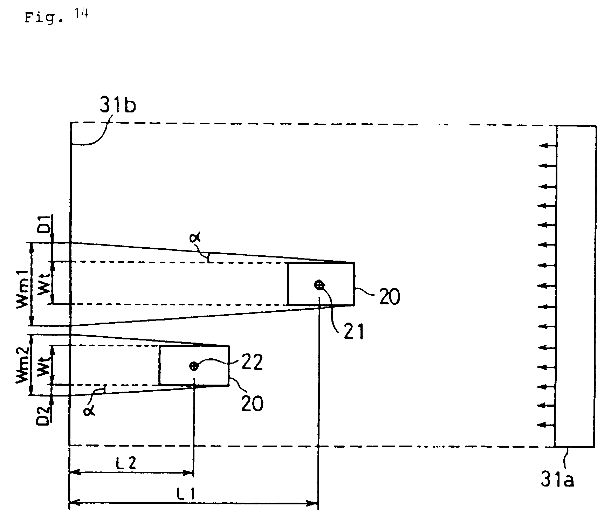

An example of the component recognition method by the component recognition device and a series of operations for picking up and mounting the chip components including that method will be hereinafter described in reference to FIGs. 14 through 17.

The estimated value of the projected width error to be stored as a correction amount in the memory means 44 is calculated from the diffusion angle of the light beams and the distance from the chip component picked up by the pickup nozzle to the light receiving section shown in FIG. 14. When parallel light beams are cast from the light emitting section 31a onto the chip component 20 picked up by the first pickup nozzle 21 and located between the light emitting section 31a and the light receiving section 31b, the light beams are diffused over the distance from the chip component 20 to the light receiving section 31b by a constant angle. Assuming the diffusion angle as a, and the distance from the chip component 20 to the light receiving section 31b as L1, light diffusion amount D1 at the light receiving section 31b is:

$$(Equation\ 1)$$

$$D1 = L1 \cdot \cos\alpha$$

Therefore, the difference $\Delta W1$ between minimum projected width Wm1 and component width Wt is

$$(Equation\ 2)$$

$$\Delta W1 = 2 \cdot D1 = 2 \cdot L1 \cdot \cos\alpha$$

When parallel light beams are cast from the light emitting section 31a onto the chip component 20 picked up by the second pickup nozzle 22 and located between the light emitting section 31a and the light receiving section 31b, since the light diffusion angle a is unchanged, assuming the distance from the chip component 20 to the light receiving section 31b as L2, light diffusion amount D2 at the light receiving section 31b is:

(Equation 3)

$$D2 = L2 \cdot \cos\alpha$$

Therefore, the difference ΔW2 between minimum projected width Wm2 and component width Wt is

(Equation 4)

$$\Delta W2 = 2 \cdot D2 = 2 \cdot L2 \cdot \cos\alpha$$

In view of the above theory, the diffusion angle α and the distances L1 and L2 (approximately the distance from the pickup nozzle to the light receiving section) are obtained in advance. Using those values and the equations 2 and 4, projected width correction amounts ΔW1 and ΔW2 are obtained for the pickup nozzles 21 and 22, and stored in the memory means 44.

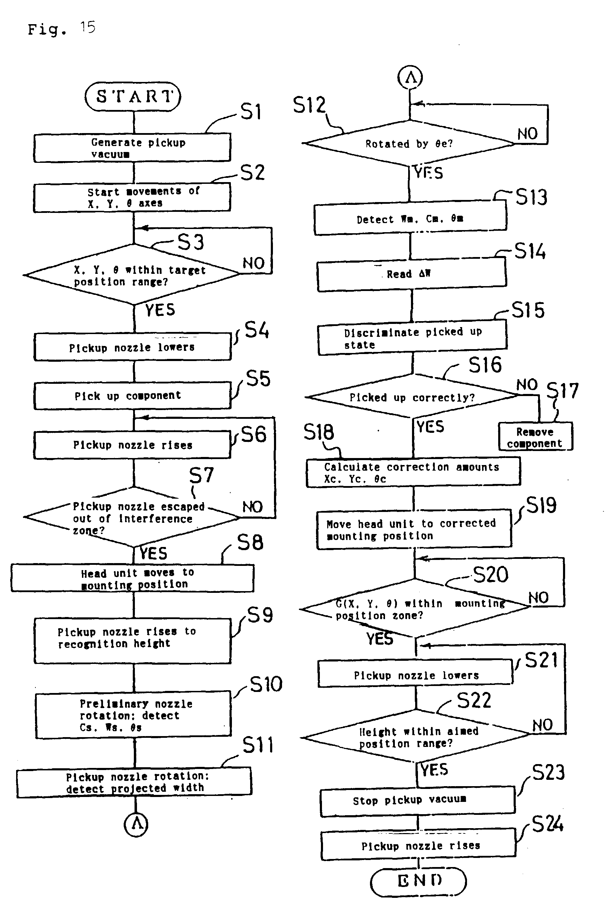

The flow chart of FIG. 15 shows a series of process from pickup to mounting. This flow chart shows the process by a single pickup nozzle. When both pickup nozzles 21 and 22 are used, the same process for the pickup, recognition, and mounting is carried out in parallel.

In this process, first in step S1, vacuum for pickup is applied from vacuum generating means (not shown) to the pickup nozzle. In step S2, an intended servomotor is driven to move the X, Y, and θ axes. In step S3, coordinates (X, Y, θ) for the pickup nozzle center are checked if the center has reached an intended position range. If reached, the pickup nozzle 21 lowers (step S4), the chip component 20 is picked up from the supply tape 4a in the component supply section 4 at a specified lowering position (step S5), and the pickup nozzle 21 rises (step S6).

In step S7, the pickup nozzle is checked if it has risen to a position out of zone of interference with the component supply section 4. If not, the pickup nozzle continues to be raised. When the pickup nozzle escapes from the interference zone, the head unit 5 is moved to the mounting position (step S8), and at the same time the pickup nozzle is raised to the component recognition height (step S9); namely the pickup nozzle 21 is raised to a height position where the chip component 20 is on the same level with the laser unit 31.

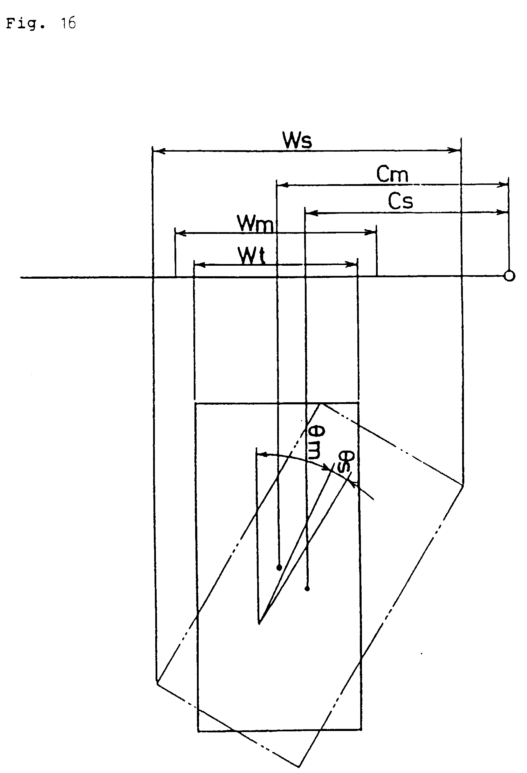

Then component recognition is effected. In this process, first the pickup nozzle 21 is rotated by a certain amount in the direction opposite to the direction in which the pickup nozzle 21 was rotated at the time of detection. Under that condition (shown in FIG. 16 with dash-and-double-dotted lines), the projected width Ws, central position Cs, and rotary angle θs of the chip component are detected (step S10). Next the projected component width is detected while the pickup nozzle 21 is being rotated in an intended direction (step S11). If a rotation angle of θe is confirmed in step S12, in step S13, the minimum value Wm of the projected widths of the chip component 20 detected during the rotation, and the central position Cm and the rotary angle·θm at the time of the occurrence of the minimum projected width of the chip component 20 are detected. In other words, the projected width of the chip component 20 is the smallest when the component is in the state shown with solid lines in FIG. 16, and at this time the projected width Wm, central position Cm, and rotary angle θm are detected (S13).

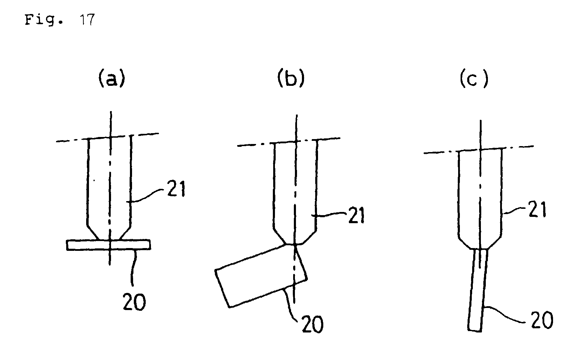

A projected width correction amount ΔW for the pickup nozzle subject to the component recognition is read from the memory means 44 (step S14). The the state of picked up component is checked (step S15). According to the result of the check, it is discriminated whether the chip component 20 is picked up correctly as shown in FIG. 17(a), or incorrectly as shown in FIGs. 17(b) and 17(c) in upright attitude (step S16). When the picked up state is incorrect (NO in the step S16), the chip component 20 is removed (step S17).

To describe more specifically the process of the steps S14 and S15 described above, the minimum projected width Wm (Wm1 or Wm2 in FIG. 14) is larger than the actual component width Wt by the amount of error in the projected width. Therefore, the component width Wt is determined by subtracting the projected width correction amount ΔW (ΔW1 or ΔW2 in FIG 14) corresponding to the projected width error from the minimum projected width Wm (namely Wt = Wm - ΔW). The component width Wt corresponds to the length of the shorter side of the component if the component is picked up correctly. Therefore, the component width Wt is checked whether or not it is within the tolerance range determined by the shorter side length of the component modified by a certain safety factor δ. If not, the pickup is discriminated as incorrect. Furthermore, the pickup is also discriminated as incorrect if the projected width does not become minimum somewhere in the course of the rotation.

In other words, it is checked whether or not the following equations are met and if any one of them is met, the pickup is discriminated as incorrect.

(Equations 5)

$$Wmin < (\text{shorter side length of component}) \times (1 - \delta)$$

$$Wmin > (\text{shorter side length of component}) \times (1 + \delta)$$

$$\theta m = \theta s$$

$$\theta m = \theta e$$

In this discrimination, the component width Wt is obtained with a high accuracy especially by the correction of the minimum projected width Wm by the amount corresponding to the projected width error due to the light diffusion described before. Since the component width Wt is obtained with a high accuracy, the safety factor $\delta$ can be made considerably small. Thus, whether or not the state of the picked up component is correct is discriminated with a high accuracy.

When the picked up state of the chip component is discriminated as correct in the step S16, the process proceeds to step S18 and to the steps after it.

In step S18, central position displacement and angular displacement of the chip component are obtained from the detected values of the minimum projected width Wm, central position Cm, and rotary angle $\theta m$. From those detected values, mounting position correction amounts Xc, Yc, and $\theta c$ are obtained respectively for X axis, Y axis, and rotary directions.

Then the head unit 5 is moved to the corrected component mounting position (step S19), coordinates (X, Y, $\theta$) for the central position G are checked whether or not they reached within the mounting position zone on the printed circuit board 3. If within, the pickup nozzle 21 lowers (step S21). When the pickup nozzle 21 comes within the intended height zone, the vacuum application is stopped, and the chip component 20 is mounted on the printed circuit board 3 (steps S22 and S23). After that, the pickup nozzle 21 rises (step S24).

The method and device of this invention is not limited to the above embodiment but various changes may be made without departing from the spirit of this invention as defined in the appendent claims.

For instance, the number of pickup nozzles provided on the head unit 5 may be more than two. In that case, if the distance from the pickup nozzle to the light receiving section 31b of the laser unit 31 is different for each nozzle, the estimated value of the projected width error due to the light diffusion may be obtained for each nozzle and stored as the correction amount in the memory section 44. The number of pickup nozzle may also be one.

The component recognition method as described is capable of obtaining chip component width with a high accuracy and improving significantly accuracy of discriminating the picked up state of the chip component by the following arrangement: When the width of the chip component picked up by the pickup nozzle is detected by the optical detection means having the parallel light emitting section and the light receiving section, to cope with the phenomenon that the projected width of the chip component is larger than the actual width of the component because of the light diffusion over the distance from the chip component to the light receiving section, the estimated value of the projected width error due to the light diffusion is obtained. When the chip component is to be recognized, the chip component width is obtained from the minimum projected width and from the correction amount determined by the estimated projected width error, and the result is compared with the reference chip component width value to discriminate whether or not the picked up state of the chip component is correct.

According to the described embodiment, the component recognition is automatically effected with the arrangement provided with; the memory means for storing the estimated value as the projected width correction amount, the measurement means for measuring the minimum projected width of the chip component by examining the projected width detected by the optical means while the chip component is being rotated, and the discrimination means for discriminating the picked up state of the chip component by comparing the chip component width obtained from the measured value by the measurement means and from the correction value read out of the memory means with the reference value.

Discrimination of the picked up state of the chip component is effected with a high accuracy when the head unit is provided with a plurality of pickup nozzles at different distances from the light receiving section and therefore even if the error amount due to the light diffusion is different for each pickup nozzle, because the estimated value of the projected width error is stored for each nozzle in the memory means.

Although the present invention has been explained by means of two embodiments thereof showing the respective means for eliminating or reducing the effects of light diffraction when recognising the chip component, it is to be noted that the method and device wherein the chip component is displaced within the parallel light beams substantially perpendicular to the parallel light beams and the method and device wherein the detection error is calculated can be combined with each other so as to recognise the chip component and its picked up state even more accurately.

**Claims**

1. Method for mounting a component (20, K) at a specific position, especially a chip component onto a substrate such as a printed circuit board (P), comprising the steps of picking up the component through a pick up nozzle (21, 22) from a component supply unit (4), transferring the component and mounting the same at the desired position, and placing the component (20,k) at a first position in a detecting area of a position detecting means (31, 127) emitting parallel light beams for detecting a projected width (W) of the component under rotation of the same so as to obtain a correction value $(X_c, Y_c, \theta_c)$ for mounting the component precisely, **characterized by** the steps of detemining whether or not data characteristics of said projected width (W) correspond with given data characteristics representing a correct pick up state, and when not, displacing the component (20, k) from said first position to a second position within said parallel light beams in a direction substantially perpendicular to said parallel light beams for detecting the projected width (W) once again.

2. Method according to the claim 1, **characterized by** the steps of calculating a detection error ($_{\Delta}$W) in said projected width (W) due to light diffraction on the basis of a distance ($L_1$,$L_2$) between the component (20, k) in the detecting area and a detecting section (31b, 127b) of said position detecting means (31, 127), calculating a component width ($W_t$) on the basis of said projected width (W) and said detection error ($_{\Delta}$W), and comparing said component width ($W_t$) with a reference value for deciding whether or not the component (20,K) is picked up correctly.

3. Method according to claim 1 and/or 2, **characterized in that** the component (20, K) being subject to the light beams is rotated through said pick up nozzle (21,22) around an axis (R-axis) substantially perpendicular to the light beams, and during rotation, the projected width (W) is repeatedly detected so as to determine the minimum projected width ($W_{min}$) of the component (20,K) and the associated rotation angle ($\theta_m$).

4. Method according to at least one of claims 1 to 3, **characterized in that** the detected projected width (W) depending on the rotation angle ($\theta$) is compared with a given change of the projected width (W) in relation to the rotation angle ($\theta$), wherein the projected width (W) gradually decreases in the course of rotation of the component (20,K) by a certain angle ($\theta_m$) and then increases again.

5. A method according to at least one of claims 1 to 4, **characterized in that** the component (20,K) is displaced within the light beams from said second position to further positions each time by a small distance ($_{\Delta}$Z) in the direction perpendicular to the light beams for detecting each time the projected width (W) at a plurality of positions within the light beams.

6. A method according to at least one of claims 1 to 5, **characterized in that** the correction values ($X_c$,$Y_c$, $\theta_c$) are calculated from the minimum projected width ($W_{min}$), central position ($C_m$) and the rotation angle ($\theta_m$) of the component relative to a centre of the pick up nozzle (21,22).

7. Method according to at least one of claims 1 to 6, **characterized in that** a plurality of components ($K_1$...$K_n$,20) is picked up successively or simultaneously, while further steps for obtaining the correction values ($X_c$,$Y_c$,$\theta_c$) for the mounting positions of the pick up nozzle (21,22) are performed at least partially in a time sharing procedure.

8. Method according to at least one of claims 1 to 7, **characterized in that** the component (20,K) is subject to laser beams emitted in parallel in a plane (X-Y) substantially perpendicular to the axis (R-axis) around which the component (20, K) is rotated.

9. Method according to at least one of claims 2 to 8, **characterized in that** the detection error ($_{\Delta}$W) is calculated from an assumed diffusion angle ($\alpha$) and said distance ($L_1$,$L_2$) between the component (20, K) and the detecting section (31b, 127b), said distance ($L_1$,$L_2$) being assumed to equal the distance between the pick up nozzle (21,22) and said detecting section (31b, 127b).

10. Method according to at least one of claims 2 to 9, **characterized in that** the detection error ($_{\Delta}$W) is calculated for each component (20, K) separately.

11. Method according to at least one of claims 2 to 10, **characterized in that** the component width ($W_t$) is calculated for each component (20, K) from the minimum projected width ($W_{min}$) measured during rotating the component (20, K) and the respective detection error data (W).

12. Mounting device for mounting a component (20, K) at a specific position, especially a chip component on to a substrate such as a printed circuit board (P) comprising a movable mounting head unit (5) supporting at least one pick up nozzle (21, 22) for picking up at least one component (20, K) from a component supply unit (4), an optical detecting means (31, 127) for detecting a projected width (W) of said component (20, K) under rotation of the same in parallel light beams emitted from said optical detecting means (31, 127), and control means (40, 130) for controlling the mounting head unit (5) and the pick up nozzle (21, 22) respectively, in response to projected width data, in particular for performing the method of claim 1, **characterized in that** a comparator means (46, 133) is provided for comparing the projected width data with reference data to determine whether or not the projected width data represents a correct pick up state, and the control means (40, 130) is adapted to displace the mounting head unit (5) and the pick up nozzle (21, 22), respectively, in a direction perpendicular to the light beams to detect the projected width (W) of the component (20, K) once again at a different position within said light beams when the projected width data does not represent a correct pick up state.

**13.** Mounting device according to claim 12, **characterized by** memory means (44) for storing a detection error ($_\Delta$W) in said projected width (W), said detection error ($_\Delta$W) being calculated on the basis of a distance ($L_1, L_2$) between the component (20, K) placed in the light beams and a detecting section (31b, 127b) of said optical detecting means (31, 127), calculating means (43) for calculating a component width ($W_t$) on the basis of a minimum projected width ($W_{min}$) and said detection error ($_\Delta$W), and by comparator mean (46, 153) for comparing the component width ($W_t$) with a reference value for deciding whether or not the component (20, K) is picked up correctly.

**14.** A mounting device according to claim 12 and/or 13, **characterized in that** the optical detecting means is formed by a laser unit (31,127) comprising an emitting section (31a,127a) for emitting parallel laser beams in a plane (X-Y) and a light receiving section (31b,127b) disposed opposite to said emitting section (31a,127a) at a lower end of said mounting head unit (5).

**15.** Mounting device according to at least one of claims 12 to 14, **characterized in that** a plurality of pick up nozzles (21,22) are each supported slidably along and rotatably about an axis that is substantially perpendicular to said plane (X-Y), relative to said mounting head unit (5) which is in turn movable in the X-axis direction and the Y-axis direction, and that servo- motors (23,24,25,26,9,15,122,124) for actuating the pick up nozzles (21,22) and the mounting head unit (5), respectively are connected with said control means (40,130).

**16.** Mounting device according to claim 15, **characterized in that** the pick up nozzles (21,22) are displaced along a line extending inclined with respect to the parallel light beams so that components (20, K) picked up do not overlap one another in a direction of said parallel light beams.

**17.** Mounting device according to at least one of claims 12 to 16, **characterized in that** the control means is formed by a main controller (40,130) including the memory means (44), the calculating means (43) and the comparator means (46,133), said main controller being connected to the laser unit (31,127) via a laser unit calculating section (32,128) and an input/output means (42,132).

**Patentansprüche**

**1.** Verfahren zum Montieren eines Bauelements (20, K) an einer spezifischen Position, insbesondere eines Chip-Bauelements, auf einem Substrat, wie beispielsweise einer gedruckten Schaltkreisleiterplatte (P), das die Schritte aufweist: Aufnehmen des Bauelements durch eine Aufnehmerdüse (21, 22) von einer Bauelementen-Zufuhreinheit (4), Überführen des Bauelements und Montieren desselben an der erwünschten Position und Plazieren des Bauelements (20, K) an einer ersten Position in einem Erfassungsbereich einer Positionserfassungseinrichtung (31, 127), die parallele Lichtstrahlen zum Erfassen einer projizierten Breite (W) des Bauelements unter Rotation desselben emittiert, um so einen Korrekturwert ($X_c$, $Y_c$, $\theta_c$) zum Montieren des Bauelements präzise zu erhalten, gekennzeichnet durch die Schritte eines Bestimmens, ob Daten-Charakteristika der projizierten Breite (W) mit gegebenen Daten-Charakteristika, die einen korrekten Aufnahme-Zustand darstellen, entsprechen oder nicht, und wenn dies nicht der Fall ist, Verschieben des Bauelements (20, K) von der ersten Position zu einer zweiten Position innerhalb der parallelen Lichtstrahlen in einer Richtung im wesentlichen senkrecht zu den parallelen Lichtstrahlen zum Erfassen der projizierten Breite (W) noch einmal.

**2.** Verfahren nach Anspruch 1, gekennzeichnet durch die Schritte eines Berechnens eines Erfassungsfehlers ($\Delta$W) in der projizierten Breite (W) aufgrund einer Lichtbrechung auf der Basis eines Abstands ($L_1$, $L_2$) zwischen dem Bauelement (20, K) in dem Erfassungsbereich und einem Erfassungsabschnitt (31b, 127b) der Positionserfassungseinrichtung (31, 127), eines Berechnens einer Bauelementen-Breite ($W_t$) auf der Basis der projizierten Breite (W) und des Erfassungsfehlers ($\Delta$W) und eines Vergleichens der Bauelementen-Breite ($W_t$) mit einem Referenzwert zum Entscheiden, ob das Bauelement (20, K) korrekt aufgenommen ist oder nicht.

**3.** Verfahren nach Anspruch 1 und/oder 2, dadurch gekennzeichnet, daß das Bauelement (20, K), das dem Lichtstrahl unterworfen ist, durch die Aufnehmer-Düse (21, 22) um eine Achse (R-Achse) im wesentlichen senkrecht zu den Lichtstrahlen rotiert wird, und daß, während der Rotation, die projizierte Breite (W) wiederholt erfaßt wird, um so die minimale, projizierte Breite ($W_{min}$) des Bauelements (20, K) und des zugeordneten Rotationswinkels ($\theta_m$) zu bestimmen.

**4.** Verfahren nach mindestens einem der Ansprüche 1 bis 3, dadurch gekennzeichnet, daß die erfaßte, projizierte Breite (W), abhängig von dem Rotationswinkel (8), mit einer gegebenen Änderung der projizierten Breite (W) in Relation zu dem Rotationswinkel ($\theta$) verglichen wird, wobei sich die projizierte Breite (W) graduell während der Rotationen des Bauelements (20, K) um einen bestimmten Winkel ($\theta_m$) erniedrigt und sich dann wieder erhöht.

5. Verfahren nach mindestens einem der Ansprüche 1 bis 4, dadurch gekennzeichnet, daß das Bauelement (20, K) innerhalb der Lichtstrahlen von der zweiten Position zu weiteren Positionen jedesmal um einen kleinen Abstand (ΔZ) in der Richtung senkrecht zu den Lichtstrahlen zum Erfassen jedesmal der projizierten Breite (W) an einer Vielzahl von Positionen innerhalb der Lichtstrahlen verschoben wird.

6. Verfahren nach mindestens einem der Ansprüche 1 bis 5, dadurch gekennzeichnet, daß die Korrekturwerte ($X_c$, $Y_c$, $\theta_c$) aus der minimalen, projizierten Breite ($W_{min}$), der zentralen Position ($C_m$) und dem Rotationswinkel ($\theta_m$) des Bauelements relativ zu einer Mitte der Aufnehmerdüse (21, 22) berechnet werden.

7. Verfahren nach mindestens einem der Ansprüche 1 bis 6, dadurch gekennzeichnet, daß eine Vielzahl von Bauelementen ($K_1...K_n$, 20) aufeinanderfolgend oder simultan aufgenommen wird, während weitere Schritte zum Erhalten der Korrekturwerte ($X_c$, $Y_c$, $\theta_c$) für die Montagepositionen der Aufnehmerdüse (21, 22) zumindest teilweise in einem Zeit-Shearing-Vorgang durchgeführt werden.

8. Verfahren nach mindestens einem der Ansprüche 1 bis 7, dadurch gekennzeichnet, daß das Bauelement (20, K) Laserstrahlen unterworfen wird, die parallel in einer Ebene (X-Y) im wesentlichen senkrecht zu der Achse (R-Achse), um die das Bauelement (20, K) herum rotiert wird, emittiert sind.

9. Verfahren nach mindestens einem der Ansprüche 2 bis 8, dadurch gekennzeichnet, daß der Erfassungsfehler (ΔW) aus einem angenommenen Diffusionswinkel (α) und dem Abstand ($L_1$, $L_2$) zwischen dem Bauelement (20, K) und dem Erfassungsabschnitt (31b, 127b) berechnet wird, wobei der Abstand ($L_1$, $L_2$) dahingehend angenommen wird, daß er gleich zu dem Abstand zwischen der Aufnehmerdüse (21, 22) und dem Erfassungsabschnitt (31b, 127b) ist.

10. Verfahren nach mindestens einem der Ansprüche 2 bis 9, dadurch gekennzeichnet, daß der Erfassungsfehler (ΔW) für jedes Bauelement (20, K) separat berechnet wird.

11. Verfahren nach mindestens einem der Ansprüche 2 bis 10, dadurch gekennzeichnet, daß die Bauelementen-Breite ($W_t$) für jedes Bauelement (20, K) aus der minimalen, projizierten Breite ($W_{min}$), gemessen während einer Rotation des Bauelements (20, K), und den jeweiligen Erfassungs-Fehler-Daten (W) berechnet wird.

12. Montagevorrichtung zum Montieren eines Bauelements (20, K) an einer spezifischen Position, insbesondere eines Chip-Bauelements, auf einem Substrat, wie beispielsweise einer gedruckten Schaltkreisleiterplatte (P), die eine bewegbare Montagekopfeinheit (5), die mindestens eine Aufnehmerdüse (21, 22) zum Aufnehmen mindestens eines Bauelements (20, K) von einer Bauelementen-Zufuhreinheit (4) trägt, eine optische Erfassungseinrichtung (31, 127) zum Erfassen einer projizierten Breite (W) des Bauelements (20, K) unter Rotation desselben in parallelen Lichtstrahlen, die von der optischen Erfassungseinrichtung (31, 127) emittiert sind, und eine Steuereinrichtung (40, 130) zum Steuern der Montagekopfeinheit (5) und der Aufnehmerdüse (21, 22) jeweils in Abhängigkeit der Daten für die projizierte Breite, insbesondere zum Durchführen des Verfahrens nach Anspruch 1, aufweist, dadurch gekennzeichnet, daß eine Vergleichseinrichtung (46, 133) zum Vergleichen der Daten über die projizierte Breite mit Referenzdaten vorgesehen ist, um zu bestimmen, ob die Daten über die projizierte Breite einen korrekten Aufnahme-Zustand darstellen oder nicht, und wobei die Steuereinrichtung (40, 130) dazu angepaßt ist, die Montagekopfeinheit (5) und die Aufnehmerdüse (21, 22) jeweils in einer Richtung senkrecht zu den Lichtstrahlen zu verschieben, um die projizierte Breite (W) des Bauelements (20, K) an einer unterschiedlichen Position innerhalb der Lichtstrahlen noch einmal zu erfassen, wenn die Daten über die projizierte Breite nicht einen korrekten Aufnahmezustand darstellen.

13. Montagevorrichtung nach Anspruch 12, gekennzeichnet durch eine Speichereinrichtung (44) zum Speichern eines Erfassungsfehlers (ΔW) in der projizierten Breite (W), wobei der Erfassungsfehler (ΔW) auf der Basis eines Abstands ($L_1$, $L_2$) zwischen dem Bauelement (20, K), plaziert in den Lichtstrahlen, und einem Erfassungsabschnitt (31b, 127b) der optischen Erfassungseinrichtung (31, 127) berechnet wird, eine Berechnungseinrichtung (43) zum Berechnen einer Bauelementen-Breite ($W_t$) auf der Basis einer minimalen, projizierten Breite ($W_{min}$) und des Erfassungsfehlers (ΔW), und durch eine Vergleichseinrichtung (46, 133) zum Vergleichen der Bauelementen-Breite ($W_t$) mit einem Referenzwert zum Entscheiden, ob das Bauelement (20, K) korrekt aufgenommen ist oder nicht.

14. Montagevorrichtung nach Anspruch 12 und/oder 13, dadurch gekennzeichnet, daß die optische Erfassungseinrichtung durch eine Lasereinheit (31, 127) gebildet ist, die einen emittierenden Abschnitt (31a, 127a) zum Emittieren paralleler Laserstrahlen in einer Ebene (X-Y) und einen Licht aufnehmenden Abschnitt (31b, 127b), angeordnet gegenüberliegend dem emittierenden Abschnitt (31a, 127a) an einem unteren Ende der Montagekopfeinheit (5), aufweist.

15. Montagevorrichtung nach mindestens einem der Ansprüche 12 bis 14, dadurch gekennzeichnet, daß eine Vielzahl von Aufnehmerdüsen (21, 22) jeweils gleitbar entlang und drehbar um eine Achse gehalten sind, die im wesentlichen senkrecht zu der Ebene (X-Y) liegt, relativ zu der Montagekopfeineit (5), die wiederum in der Richtung der X-Achse und in der Richtung der Y-Achse bewegbar ist, und daß Servomotoren (23, 24, 25, 26, 9, 15, 122, 124) zum Betätigen der Aufnehmerdüsen (21, 22) und der Montagekopfeinheit (5) jeweils mit der Steuereinrichtung (40, 130) verbunden sind.

16. Montagevorrichtung nach Anspruch 15, dadurch gekennzeichnet, daß die Aufnehmerdüsen (21, 22) entlang einer Linie verschoben werden, die sich geneigt in Bezug auf die parallelen Lichtstrahlen erstreckt, so daß Bauelemente (20, K), die aufgenommen sind, nicht miteinander in einer Richtung der parallelen Lichtstrahlen überlappen.

17. Montagevorrichtung nach mindestens einem der Ansprüche 12 bis 16, dadurch gekennzeichnet, daß die Steuereinrichtung durch eine Hauptsteuereinrichtung (40, 130), umfassend die Speichereinrichtung (44), die Berechnungseinrichtung (43) und die Vergleichseinrichtung (46, 133) gebildet ist, wobei die Hauptsteuereinrichtung mit der Lasereinheit (31, 127) über einen Lasereinheit-Berechnungsabschnitt (32, 128) und eine Eingabe/Ausgabeeinrichtung (42, 132) verbunden ist.

**Revendications**

1. Méthode pour le montage d'un composant (20, K) à une position spécifique, en particulier d'un composant à puce sur un substrat tel qu'une carte (P) à circuit imprimé, comprenant les étapes de saisie du composant par une buse de saisie (21, 22) depuis une unité (4) de fourniture de composants, de transfert du composant et de son montage à la position souhaitée, et de placement du composant (20, K) à une première position dans une aire de détection de moyens (31, 127) de détection de position, émettant des faisceaux lumineux parallèles, pour détecter une largeur projetée (W) du composant lors de sa rotation afin d'obtenir une valeur de correction $(X_c, Y_c, \theta_c)$ pour monter le composant précisément, caractérisée par les étapes de détermination de la correspondance ou non de caractéristiques de données de ladite largeur projetée (W) avec des caractéristiques de données fixées représentant un état de saisie correcte, et si non, de déplacement du composant (20, K) de ladite première position à une deuxième position dans lesdits faisceaux lumineux parallèles dans une direction sensiblement perpendiculaire auxdits faisceaux lumineux parallèles pour détecter la largeur projetée (W) une fois de plus.

2. Méthode selon la revendication 1, caractérisée par les étapes de calcul d'une erreur de détection $(\Delta W)$ dans ladite largeur projetée (W) due à la diffraction de la lumière sur la base d'une distance $(L_1, L_2)$ entre le composant (20, K) dans l'aire de détection et une section de détection (31b, 127b) desdits moyens (31, 127) de détection de position, de calcul d'une largeur de composant $(W_t)$ sur la base de ladite largeur projetée (W) et de ladite erreur de détection $(\Delta W)$, et de comparaison de ladite largeur de composant $(W_t)$ avec une valeur de référence pour décider si le composant (20, K) est saisi correctement ou non.

3. Méthode selon la revendication 1 et/ou 2, caractérisée en ce que le composant (20, K) soumis aux faisceaux lumineux est tourné par ladite buse de saisie (21,22) autour d'un axe (axe R) sensiblement perpendiculaire aux faisceaux lumineux, et pendant la rotation, la largeur projetée (W) est détectée de façon répétée afin de déterminer la largeur projetée minimale $(W_{min})$ du composant (20, K) et l'angle de rotation $(\theta_m)$ associé.

4. Méthode selon au moins l'une des revendications 1 à 3, caractérisée en ce que la largeur projetée détectée (W) fonction de l'angle de rotation $(\theta)$ est comparée à un changement donné de la largeur projetée (W) par rapport à l'angle de rotation $(\theta)$, où la largeur projetée (W) diminue progressivement au cours de la rotation du composant (20, K) d'un certain angle $(\theta_m)$ et ensuite augmente de nouveau.

5. Méthode selon au moins l'une des revendications 1 à 4, caractérisée en ce que le composant (20, K) est déplacé dans les faisceaux lumineux de ladite deuxième position à d'autres positions, à chaque fois d'une petite distance $(\Delta Z)$ dans la direction perpendiculaire aux faisceaux lumineux, pour détecter à chaque fois la largeur projetée (W) à une pluralité de positions dans les faisceaux lumineux.

6. Méthode selon au moins l'une des revendications 1 à 5, caractérisée en ce que les valeurs de correction $(X_c, Y_c, \theta_c)$ sont calculées à partir de la largeur projetée minimale $(W_{min})$, de la position centrale $(C_m)$ et de l'angle de rotation $(\theta_m)$ du composant par rapport à un centre de la buse de saisie (21,22).

7. Méthode selon au moins l'une des revendications 1 à 6, caractérisée en ce qu'une pluralité de composants ($K_1$,...,$K_n$,20) est saisie successivement ou simultanément, tandis que des étapes ultérieures pour obtenir les valeurs de correction ($X_c$,$Y_c$,$\theta_c$) pour les positions de montage de la buse de saisie (21,22) sont effectuées au moins partiellement dans une procédure de partage de temps.

8. Méthode selon au moins l'une des revendications 1 à 7, caractérisée en ce que le composant (20, K) est soumis à des faisceaux laser émis en parallèle dans un plan (X-Y) sensiblement perpendiculaire à l'axe (axe R) autour duquel le composant (20, K) est tourné.

9. Méthode selon au moins l'une des revendications 2 à 8, caractérisée en ce que l'erreur de détection ($\Delta W$) est calculée à partir d'un angle de diffusion supposé ($\alpha$) et de ladite distance ($L_1$,$L_2$) entre le composant (20, K) et la section de détection (31b, 127b), ladite distance ($L_1$,$L_2$) étant supposée être égale à la distance entre la buse de saisie (21,22) et ladite section de détection (31b, 127b).

10. Méthode selon au moins l'une des revendications 2 à 9, caractérisée en ce que l'erreur de détection ($\Delta W$) est calculée pour chaque composant (20, K) séparément.

11. Méthode selon au moins l'une des revendications 2 à 10, caractérisée en ce que la largeur de composant ($W_t$) est calculée pour chaque composant (20, K) à partir de la largeur projetée minimale ($W_{min}$) mesurée pendant la rotation du composant (20, K) et de la donnée d'erreur de détection ($\Delta W$) respective.

12. Dispositif de montage pour monter un composant (20, K) à une position spécifique, en particulier un composant à puce sur un substrat tel qu'une carte (P) à circuit imprimé, comprenant une unité mobile de tête de montage (5) supportant au moins une buse de saisie (21, 22) pour saisir au moins un composant (20, K) depuis une unité (4) de fourniture de composants, des moyens de détection optique (31, 127) pour détecter une largeur projetée (W) dudit composant (20, K) lors de sa rotation dans des faisceaux lumineux parallèles émis depuis lesdits moyens de détection optique (31, 127), et des moyens de commande (40, 130) pour commander l'unité de tête de montage (5) et la buse de saisie (21, 22), respectivement, en réponse à une donnée de largeur projetée, en particulier pour effectuer la méthode de la revendication 1, caractérisé en ce que des moyens de comparaison (46, 133) sont fournis pour comparer la donnée de largeur projetée avec des données de référence pour déterminer si la donnée de largeur projetée représente ou non un état de saisie correcte, et les moyens de commande (40, 130) sont adaptés pour déplacer l'unité de tête de montage (5) et la buse de saisie (21, 22), respectivement, dans une direction perpendiculaire aux faisceaux lumineux pour détecter la largeur projetée (W) du composant (20, K) une fois de plus, à une position différente dans lesdits faisceaux lumineux, lorsque la donnée de largeur projetée ne représente pas un état de saisie correcte.

13. Dispositif de montage selon la revendication 12, caractérisé par des moyens de mémoire (44) pour stocker une erreur de détection ($\Delta W$) dans ladite largeur projetée (W), ladite erreur de détection ($\Delta W$) étant calculée sur la base d'une distance ($L_1$,$L_2$) entre le composant (20, K) placé dans les faisceaux lumineux et une section de détection (31b, 127b) desdits moyens (31, 127) de détection optique, par des moyens de calcul (43) pour calculer une largeur de composant ($W_t$) sur la base d'une largeur projetée minimale ($W_{min}$) et de ladite erreur de détection ($\Delta W$), et par des moyens de comparaison (46, 133) pour comparer la largeur de composant ($W_t$) avec une valeur de référence pour décider si le composant (20, K) est saisi correctement ou non.

14. Dispositif de montage selon la revendication 12 et/ou 13, caractérisé en ce que les moyens de détection optique sont formés par une unité laser (31,127) comprenant une section d'émission (31a, 127a) pour émettre des faisceaux laser parallèles dans un plan (X-Y) et une section de réception de lumière (31b,127b) disposée en face de ladite section d'émission (31a,127a) à une extrémité inférieure de ladite unité de tête de montage (5).

15. Dispositif de montage selon au moins l'une des revendications 12 à 14, caractérisé en ce qu'une pluralité de buses de saisie (21,22) sont supportées de façon à coulisser et à tourner sur un axe qui est sensiblement perpendiculaire audit plan (X-Y), par rapport à ladite unité de tête de montage (5) qui est à son tour mobile dans la direction de l'axe X et la direction de l'axe Y, et en ce que des servomoteurs (23,24,25,26,9,15,122,124) pour actionner les buses de saisie (21,22) et l'unité de tête de montage (5), respectivement, sont connectés auxdits moyens de commande (40,130).

16. Dispositif de montage selon la revendication 15, caractérisé en ce que les buses de saisie (21,22) sont déplacées le long d'une ligne s'étendant de façon inclinée relativement aux faisceaux lumineux parallèles, de telle sorte que des composants (20, K) saisis ne se chevauchent pas les uns les autres dans une direction desdits faisceaux lumineux parallèles.

17. Dispositif de montage selon au moins l'une des revendications 12 à 16, caractérisé en ce que les moyens de commande sont formés par un contrôleur principal (40,130) incluant les moyens de mémoire (44), les moyens de calcul (43) et les moyens de comparaison (46,133), ledit contrôleur principal étant connecté à l'unité laser (31,127) via une section de calcul (32,128) d'unité laser et des moyens d'entrée/sortie (42,132).

Fig. 1

Fig. 2

Fig. 3

Fig. 4

EP 0 660 656 B1

Fig. 5

Fig. 6

```
                    ┌─────────────┐
                    │  S T A R T  │
                    └──────┬──────┘
                           │←───────────────────────────┐
                           ▼                             │
              ╱──────────────────────╲                  │
   S20       ╱  PICKUP NOZZLE RAISED TO ╲     NO         │
     ╲──────╱   RECOGNITION HEIGHT;      ╲───────────────┘
             ╲  PRELIMINARY ROTATION     ╱
              ╲ COMPLETE?               ╱
               ╲──────────┬───────────╱
                     YES  │
   S21                    ▼
     ╲─────┌────────────────────────┐
          │  DETECTING Cs. Ws. θs    │
          └───────────┬────────────┘
          ┌───────────┼──────────────────────────────────────────────────┐
   S22    │           ▼                                                    │
     ╲────┌────────────────────────┐                                      │
          │ PICKUP NOZZLE ROTATION:  │                                     │
          │ MINIMUM COMPONENT PRO-   │                                     │
          │ JECTED WIDTH DETECTION   │                                     │
          └───────────┬────────────┘                                      │
   S23               ▼                                                     │
     ╲──── ╱──────────────────────╲                                       │
     NO   ╱  PICKUP NOZZLE ROTATION ╲                                      │
    ┌─────╲   BY θe?                ╱                                      │
    │      ╲──────────┬───────────╱                                       │
    │            YES  │                                                    │
    │  S24            ▼                                                    │
    │    ╲─── ╱──────────────────╲   NO    ┌─────────┐   ┌──────────┐  ┌──────────────┐
    │        ╱  PROJECTED WIDTH W  ╲───────│ N = N+1 │───│  N > n   │───│ PICKUP NOZZLE│
    │        ╲  DATA OK?           ╱       └─────────┘   └────┬─────┘ NO│ MOVE ΔZ      │
    │         ╲──────────┬───────╱          S29         S30   │         └──────┬───────┘
    │               YES  │                              YES   │        S31     │
    │  S25              ▼                                 ▼                     │
    │    ╲───┌────────────────────────┐        S32 ┌──────────────┐            │
    │        │ DETECTING Wmin. Cm. θm   │          │ ERROR DISPLAY │            │
    │        └───────────┬────────────┘           └──────────────┘            │
    │  S26              ▼                                                       │
    │    ╲─── ╱──────────────────╲   NO                                        │
    │        ╱  COMPONENT PICKUP   ╲──────────┐                                │
    │        ╲  CORRECT            ╱          ▼                                │
    │         ╲──────────┬───────╱      ┌──────────────┐  S28                  │
    │               YES  │              │ COMPONENT    │                       │
    │  S27              ▼              │ REMOVAL      │                        │
    │    ╲───┌────────────────────────┐└──────────────┘                       │
    │        │ CALCULATING CORRECTION   │                                      │
    │        │ AMOUNTS Xc. Yc. θc       │                                      │
    │        └───────────┬────────────┘                                       │
    │                    ▼                                                     │
    │             ┌─────────────┐                                             │
    │             │   E N D     │                                             │
    │             └─────────────┘                                             │
```

Fig. 7

Fig. 8

Fig. 9

Fig. 10

Fig. 11

Fig. 12

31b        22        31a     31
           21

Fig. 13

Fig. 14

Fig. 15

```
                START
                  │ S1
         ┌────────────────────┐
         │ Generate pickup    │
         │ vacuum             │
         └────────────────────┘
                  │ S2
         ┌────────────────────┐
         │ Start movements of │
         │ X, Y, θ axes       │
         └────────────────────┘
                  │        S3
              ◇────────────────────◇  NO
              │ X, Y, θ within target│───┐
              │ position range?      │   │
              ◇────────────────────◇    │
                  │ YES                  │
         ┌────────────────────┐  S4      │
         │ Pickup nozzle lowers│         │
         └────────────────────┘          │
                  │        S5            │
         ┌────────────────────┐          │
         │ Pick up component  │          │
         └────────────────────┘          │
                  │        S6            │
         ┌────────────────────┐          │
         │ Pickup nozzle rises│◄─────────┘
         └────────────────────┘
                  │        S7
              ◇────────────────────◇  NO
              │ Pickup nozzle escaped│───┐
              │ out of interference  │   │
              │ zone?                │   │
              ◇────────────────────◇    │
                  │ YES       S8         │
         ┌────────────────────┐          │
         │ Head unit moves to │◄─────────┘
         │ mounting position  │
         └────────────────────┘
                  │        S9
         ┌────────────────────┐
         │ Pickup nozzle rises to│
         │ recognition height │
         └────────────────────┘
                  │        S10
         ┌────────────────────┐
         │ Preliminary nozzle │
         │ rotation: detect   │
         │ Cs, Ws, θs         │
         └────────────────────┘
                  │        S11
         ┌────────────────────┐
         │ Pickup nozzle rotation:│
         │ detect projected width │
         └────────────────────┘
                  │
                 (A)
```

```
                 (A)
                  │           S12
              ◇────────────────────◇  NO
              │ Rotated by θe?       │───┐
              ◇────────────────────◇    │
                  │ YES                  │
         ┌────────────────────┐  S13     │
         │ Detect Wm, Cm, θm  │          │
         └────────────────────┘          │
                  │        S14           │
         ┌────────────────────┐          │
         │ Read ΔW            │          │
         └────────────────────┘          │
                  │        S15           │
         ┌────────────────────┐          │
         │ Discriminate picked up│       │
         │ state              │          │
         └────────────────────┘          │
                  │      S16             │
              ◇────────────────────◇  NO  S17
              │ Picked up correctly? │───┐
              ◇────────────────────◇   │
            S18   │ YES            ┌────────┐
         ┌────────────────────┐   │ Remove │
         │ Calculate correction│   │component│
         │ amounts Xc, Yc, θc │   └────────┘
         └────────────────────┘
                  │        S19
         ┌────────────────────┐
         │ Move head unit to corrected│
         │ mounting position  │
         └────────────────────┘
                  │        S20
              ◇────────────────────◇  NO
              │ G(X, Y, θ) within mounting│───┐
              │ position zone?       │      │
              ◇────────────────────◇       │
                  │ YES                     │
         ┌────────────────────┐  S21        │
         │ Pickup nozzle lowers│◄───────────┘
         └────────────────────┘
                  │        S22
              ◇────────────────────◇  NO
              │ Height within aimed  │───┐
              │ position range?      │   │
              ◇────────────────────◇   │
                  │ YES        S23      │
         ┌────────────────────┐         │
         │ Stop pickup vacuum │◄────────┘
         └────────────────────┘
                  │        S24
         ┌────────────────────┐
         │ Pickup nozzle rises│
         └────────────────────┘
                  │
                 END
```

Fig. 16

Fig. 17

(a)           (b)           (c)